# EUROPÄISCHE PATENTANMELDUNG

(11) **EP 2 133 915 A1**
(43) Veröffentlichungstag der Anmeldung: **16.12.2009**
(21) Anmeldenummer: 08010430.0
(22) Anmeldetag: 09.06.2008
(51) Int. Cl.: H01L 23/485, H01L 21/60, H01L 25/065

(54) **Halbleiteranordnung mit besonders gestalteten Bondleitungen und Verfahren zum Herstellen einer solchen Anordnung**

(71) Anmelder: Micronas GmbH, 79108 Freiburg (DE)
(72) Erfinder: Stumpf, Pascal, 68180 Horbourg-Wihr (FR)
(74) Vertreter: Göhring, Robert

(57) **Zusammenfassung**

Die Erfindung betrifft eine Halbleiteranordnung und ein Verfahren zum Herstellen einer solchen Halbleiteranordnung mit mindestens zwei in einem Gehäuse angeordneten integrierten Schaltkreisen (IC1,IC2), welche über Bondleitungen (10) miteinander elektrisch verbunden sind. Mindestens eine der Bondleitungen (10) ist mit ihrem ersten, vorzugsweise kugelförmigen Ende (12) auf ein Anschlusspad eines ersten integrierten Schaltkreises (IC1) angeschlossen. Das andere, keilförmig gestaltete Ende (14) der Bondleitung (10) ist mit einem Anschlusspad (6) des zweiten integrierten Schaltkreises (IC2) über ein ebenfalls vorzugsweise kugelförmiges Zwischenelement (20) angeschlossen. Das Zwischenelement (20) besteht aus einem weicheren Material als die Bondleitung (10). Bevorzugt besteht die Bondleitung (10) aus Kupfer oder einer Kupferlegierung und das Zwischenelement (20) aus Gold oder einer Goldlegierung.

## Beschreibung

Die Erfindung betrifft eine Halbleiteranordnung mit mindestens zwei in einem Gehäuse angeordneten integrierten Schaltkreisen, die über Bondleitungen miteinander elektrisch verbunden sind gemäß den Merkmalen des Oberbegriffes des Anspruchs 1 sowie ein Verfahren zum Herstellen einer solchen Halbleiteranordnung.

Bondleitungen oder Bonddrähte sind bei der Herstellung von integrierten Schaltkreisen hinlänglich bekannt. Solche Bondleitungen werden einerseits dazu benutzt, bei einem integrierten Schaltkreis die außerhalb des Gehäuses sichtbaren Anschlüsse (auch "pins" genannt) mit dem im Inneren des Gehäuses liegenden Chip zu verbinden. Hierfür weist der Chip elektrische Anschlussbereiche, sogenannte "Bond-Inseln" oder "Pads" auf. Mit der Bondleitung wird eine elektrische Verbindung zwischen der eigentlichen integrierten Schaltung und dem Verdrahtungsträger eines elektronischen Schaltkreises erzeugt. In der Regel wird die Bondleitung von den Anschlusspads des Chips zu dem inneren Teil des Anschlusses gezogen und an beiden Stellen mechanisch und elektrisch angeschlossen. Bekannt ist das sogenannte Thermosonic-Bonden und das Ultrasonic-Bonden. Nach dem Bonden werden die integrierten Schaltkreise hermetisch in ein Gehäuse, vorzugsweise Kunststoffgehäuse, eingegossen. In der mikroelektronischen Aufbau- und Verbindungstechnik besteht die Bondleitung meist aus Gold oder einer Goldlegierung. Es sind auch Bondleitungen aus Aluminium bekannt.

Bondleitungen werden aber nicht nur dazu benutzt, einen im Gehäuse befindlichen Chip mit den äußeren Anschlüssen am Gehäuse elektrisch zu verbinden. Bondleitungen werden auch dazu benutzt, Chips innerhalb eines Gehäuses miteinander elektrisch zu verbinden. Hierfür weisen die im Gehäuse befindlichen integrierten Schaltkreise jeweils Anschlusspads auf, die mit solchen Bondleitungen elektrisch verbunden werden. Nach G.G. Harman "Wire Bonding in Microelectronics" McGraw-Hill, 1997, Seiten 1-10, Seiten 67ff und Seiten 203ff, wird bei dem bekannten Ball-Wedge-Verfahren der Bonddraht mittels einer abgeflammten Kugel, die auch als Free-Air-Ball (FAB) bezeichnet wird, auf den Anschlusspad eines ersten integrierten Schaltkreises gebondet und am anderen Ende keilförmig abgequetscht und mit dem Anschlusspad des zweiten integrierten Schaltkreises verbunden.

Problematisch bei diesem Ball-Wedge-Verfahren ist die Druckbeanspruchung des zweiten integrierten Schaltkreises, also desjenigen Schaltkreises, bei dem der Bonddraht abgequetscht und meist mittels Ultraschallunterstützung auf den Anschlusspad des zweiten integrierten Schaltkreises aufgedrückt wird. Um die Druckbeanspruchung des zweiten integrierten Schaltkreises zu reduzieren, ist es bekannt, sogenannte kugelförmige Zwischenelemente aus elektrisch leitfähigem Material vorzusehen, die auf dem Anschlusspad des zweiten integrierten Schaltkreises sitzen. Das keilförmig abgeflachte zweite Ende der Bondleitung wird auf dieses kugelförmige Zwischenelement aufgedrückt. Dieses Zwischenelement dient zur Druckentlastung.

Bondleitungen bestehen meist aus Gold, obwohl dies gegenüber Kupfer und Silber schlechtere elektrische und mechanische Eigenschaften aufweist. Der Grund hierin liegt im Anlaufverhalten, also in der Oxidation des Kupfers, bei Sauerstoffberührung. Durch diese Oxidation des Kupfers verliert die aus Kupfer bestehende Bondleitung ihre Bondfähigkeit. Es wird deshalb bei der Verwendung von Bondleitungen aus Kupfer häufig das Bonden in Schutzgas durchgeführt, um die Oxidation des Kupfers zu verhindern. Bisher haben sich Bondleitungen aus Gold bei der Chip-Zu-Chip-Verbindung bestens bewährt. Problematisch bei den Bondleitungen aus Gold ist jedoch der hohe Goldpreis. Aufgrund der immer besseren Eigenschaften von integrierten Schaltkreisen und der immer höheren Packungsdichte innerhalb von Gehäusen sind eine Unmenge von Bondleitungen in einer Halbleiteranordnung notwendig. Es können mehrere Hundert bis Tausend solcher Bondleitungen notwendig werden. Bei der Verwendung von Bondleitungen aus Gold fällt dies kostenmäßig stark ins Gewicht.

Es sind deshalb bereits Versuche bekannt geworden, die teuren Bondleitungen aus Gold durch günstigere Materialien zu ersetzen.

Zur Kosteneinsparung gegenüber Golddrähten werden gemäß US 2003/0113574 A1 goldummantelte Silber- oder Palladiumdrähte bereitgestellt.

Aus DE 10 2005 011028 A1 ist zudem bekannt, Kupfer-Gold-Legierungen zu verwenden. Kupfer-Gold-Legierungen zeichnen sich durch eine gegenüber Gold deutlich erhöhte Härte aus. Diese Härte ist allerdings für Bonddrähte unerwünscht, da durch das Anpressen des Bonddrahtes bzw. der Bondleitung auf die Anschlusspads des integrierten Schaltkreises der integrierte Schaltkreis beschädigt werden kann. Auf Kupferdrähten befindliche Gold-Kupfer-Legierungen können beim Andrücken auf die Anschlusspads zu Rissen im Siliziumchip des integrierten Schaltkreises führen, wodurch der integrierte Schaltkreis möglicherweise ausfällt.

Die DE 10 2005 011028 A1 schlägt des Weiteren eine Bondleitung aus Kupfer vor, in deren Oberfläche eine geringe Menge Gold enthalten ist. Besonders bevorzugt wird in der genannten Veröffentlichung vorgeschlagen, eine Bondleitung aus Kupfer mit in der Oberfläche angereichertem Gold in einer Menge, die einer Ummantelung von maximal 50, insbesondere maximal 50 nm entsprechen würde, wenn sich das Gold gleichmäßig als Schicht auf dem Draht ausbilden würde.

Problematisch bei einem solchen goldbeschichteten Kupferdraht als Bondleitung ist der Umstand, dass die Herstellung eines solchen goldbeschichteten Kupferdrahtes verhältnismäßig aufwändig ist, wodurch ebenfalls die Kosten erhöht sind.

Der Erfindung liegt deshalb die Aufgabe zugrunde, eine Halbleiteranordnung mit einer Bondleitung bereitzustellen, die im Vergleich zu den bisherigen Bondleitungen deutlich kostengünstiger ist.

Diese Aufgabe wird durch eine Halbleiteranordnung mit den Merkmalen des Anspruchs 1 gelöst.

Weiterbildungen dieser Halbleiteranordnung sind Gegenstand der Unteransprüche.

Ein Verfahren zum Herstellen einer solchen Halbleiteranordnung ist Gegenstand des Anspruchs 10. Dieses Verfahren sieht folgende Schritte vor:
- Bereitstellen eines ersten integrierten Schaltkreises (IC1) mit mindestens einem ersten Anschlusspad (3),
- Bereitstellen eines zweiten integrierten Schaltkreises (IC2) mit mindestens einem zweiten Anschlusspad (6),
- Bereitstellen einer Bondleitung zum elektrischen Verbinden des ersten Anschlusspads (3) und des zweiten Anschlusspads (6),
- Aufbringen eines elektrisch leitfähigen Zwischenelements auf dem Anschlusspad (6) des zweiten integrierten Schaltkreises (IC2) derart, dass das elektrisch leitfähige Zwischenelement (20) elektrisch leitend mit dem Anschlusspad (6) des zweiten integrierten Schaltkreises (IC2) in Verbindung steht,
- mechanisches Befestigen eines ersten Endes (12) der Bondleitung (10) auf dem Anschlusspad (3) des ersten integrierten Schaltkreises (IC1),
- mechanisches Befestigen eines zweiten, keilförmigen Endes (14) der Bondleitung (10) auf dem Zwischenelement (20), wobei
- das Material des Zwischenelementes (20) weicher gewählt wird als das Material der Bondleitung (10).

Weiterbildungen dieses Verfahrensanspruches sind in den Ansprüchen 11 und 12 angegeben.

Die erfindungsgemäße Halbleiteranordnung zeichnet sich dadurch aus, dass Bondleitungen aus einem einheitlichen Material, das deutlich günstiger als Gold ist, verwendet werden können. Die Verwendung von kompliziert hergestellten Bondleitungen, die bspw. mit Gold beschichtet wurden, macht die vorliegende Erfindung entbehrlich. Dies wird dadurch erreicht, dass das keilförmige Ende der Bondleitung, die bspw. aus Kupfer oder einer Kupferlegierung besteht, nicht unmittelbar auf ein Anschlusspad einer integrierten Schaltung aufgebracht wird, sondern dieses keilförmige Ende der Bondleitung auf ein Zwischenelement, das auf dem Anschlusspad des integrierten Schaltkreises sitzt, aufgebracht und dort kontaktiert wird. Dieses Zwischenelement ist vorzugsweise kugelförmig oder annähernd kugelförmig gestaltet und besteht aus einem weicheren Material als die Bondleitung. Bevorzugt wird das Zwischenelement aus Gold, einer Goldlegierung oder dotiertem Gold bestehen.

Dadurch, dass das Zwischenelement zwischen das keilförmige Ende der Bondleitung und dem Anschlusspad des integrierten Schaltkreises platziert ist, wird beim Aufdrücken des keilförmigen Endes der Bondleitung der Druck nicht unmittelbar in den Halbleiterkörper des integrierten Schaltkreises weitergeleitet, sondern zunächst von dem Zwischenelement abgefangen. Die mechanische Belastung des integrierten Schaltkreises ist somit deutlich gegenüber herkömmlichen Verfahren, bei denen das keilförmige Ende der Bondleitung unmittelbar auf den Anschlusspad des integrierten Schaltkreises gedrückt wird, reduziert.

Es liegt im Rahmen der Erfindung, dass die Bondleitung die Anschlusspads von zwei integrierten Schaltkreisen, die in einem gemeinsamen Gehäuse untergebracht sind, kontaktiert. Die beiden integrierten Schaltkreise können nebeneinander oder übereinander angeordnet sein. Die Bondleitung hat vorzugsweise einen Durchmesser von 20-30 µm und eine Vickershärte < 70.

Die erfindungsgemäße Halbleiteranordnung und deren Herstellverfahren wird anschließend im Zusammenhang mit Ausführungsbeispielen im Zusammenhang mit Figuren näher erläutert. Es zeigen:
- Fig. 1: ein erstes Ausführungsbeispiel mit zwei in einem Ge- häuse nebeneinander angeordneten integrierten Schalt- kreisen IC1, IC2, die mit einer Bondleitung verbunden sind,
- Fig. 2: zwei übereinander in einem Gehäuse angeordnete integ- rierte Schaltkreise, welche ebenfalls über eine Bond- leitung miteinander elektrisch kontaktiert sind und
- Fig. 3: eine Rasterelektronenmikroskop-Aufnahme der Bondlei- tung von Fig. 1 bzw. Fig. 2 im Bereich eines keilför- migen Endes der Bondleitungen von Fig. 1 und Fig. 2.

In den nachfolgenden Figuren bezeichnen, sofern nicht anders angegeben, gleiche Bezugszeichen gleiche Teile mit gleicher Bedeutung.

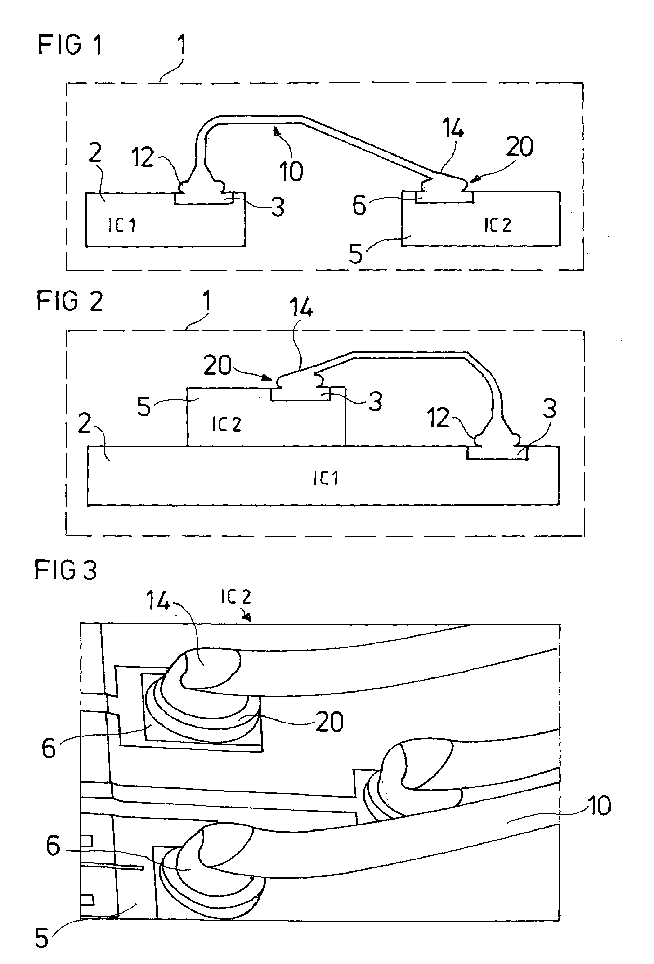

In Figur 1 ist ein Gehäuse 1 einer integrierten Halbleiteranordnung dargestellt. In dem Gehäuse sitzen nebeneinander zwei integrierte Schaltkreise IC1, IC2. Der erste integrierte Schaltkreis IC1 weist einen ersten Halbleiterkörper 2 mit Anschlusspads 3 auf, wobei einer dieser Anschlusspads 3 in Fig. 1 zu erkennen ist. Der zweite integrierte Schaltkreis IC2 verfügt über einen zweiten Halbleiterkörper 5, auf dessen oberer Fläche ebenfalls ein Anschlusspad 6 zu erkennen ist. Die Anschlusspads 3 bzw. 6 der beiden integrierten Schaltkreise IC1, IC2 sind entsprechend den elektrischen Erfordernissen der Halbleiteranordnung elektrisch über Bondleitungen 10 miteinander verbunden. Eine dieser Bondleitungen 10 ist in Fig. 1 dargestellt. Die Bondleitung 10 besteht aus einem Material, das deutlich kostengünstiger als Gold ist. Als Material für die Bondleitung 10 eignet sich z. B. Kupfer oder eine Kupferlegierung.

Die Bondleitung 10 wird an den ersten integrierten Schaltkreis IC1 nach dem bekannten Ball-Wedge-Verfahren (Ball-Wedge-Bonden) angeschlossen. Andere Anschlussverfahren sind ebenfalls möglich. Beim Ball-Wedge-Bonden wird mittels eines geeigneten Werkzeuges die Bondleitung 10 innerhalb einer Kapillare aus Sintermetall oder Keramik geführt. Mittels einer Flamme oder einer elektrischen Entladung wird das an der Kapillare unten herausstehende Ende der Bondleitung 10 angeschmolzen, sodass sich durch die Oberflächenspannung eine Kugel bildet. Diese Kugel wird unter Druck, Wärme und Ultraschall auf das Anschlusspad 3 des Halbleiterkörpers 2 des ersten integrierten Schaltkreises IC1 gebondet. Dabei wird die Kugel durch die Kapillare etwas auseinandergedrückt, sodass eine Art Nagelkopf entsteht. Dieses kugelförmige Ende der Bondleitung 10 ist in Fig. 1 mit dem Bezugszeichen 12 versehen.

Die Bondleitung 10 wird dann zur zweiten Kontaktstelle geführt, hier also in dem Ausführungsbeispiel von Fig. 1 zu dem Anschlusspad 6 des Halbleiterkörpers 5 des zweiten integrierten Schaltkreises IC2. Im Gegensatz zu herkömmlichen Techniken wird allerdings die Bondleitung 10 nicht unmittelbar auf das Anschlusspad 6 aufgedrückt. Vielmehr ist in einem vorausgegangenen Verfahrensschritt auf dieses Anschlusspad 6 ein Zwischenelement 20, das vorzugsweise kugelförmig oder mindestens annähernd kugelförmig geformt ist, aufgesetzt worden. Dieses Zwischenelement 20 besteht aus einem weicheren Material als die Bondleitung 10, bspw. aus einem weicheren Material als Kupfer, sofern für die Bondleitung 10 Kupfer verwendet wird. Als geeignetes Material hat sich Gold, eine Goldlegierung oder dotiertes Gold herausgestellt.

Die Bondleitung 10 wird also zu dem Anschlusspad 6 mit dem aufgesetzten Zwischenelement 20 geführt. Die Bondleitung 10 wird mittels Ultraschall, Wärme und Druck auf das Zwischenelement 20 aufgesetzt und festgebondet. Eine oberhalb der Kapillare des Bondwerkzeuges angebrachte Drahtklammer verhindert beim Abheben des Werkzeuges, dass die Bondleitung 10 nachgeführt wird, stattdessen wird die Bondleitung 10 im Bereich des Zwischenelementes 20 abgerissen. Es entsteht ein keilförmiges Ende 14 der Bondleitung 10, die mit dem Zwischenelement 20 elektrisch in Verbindung steht.

Dieses kugelförmige Zwischenelement 20 kann bspw. mit einem zweiten Werkzeug auf das Anschlusspad 6 des Halbleiterkörpers 5 des zweiten integrierten Schaltkreises IC2 aufgesetzt werden. Dabei kann das zweite Werkzeug wieder eine Kapillare aus Sintermetall oder Keramik sein. Wie bei der Gestaltung des kugelförmigen Endes 12 der Bondleitung 10 wird bspw. ein Golddraht durch die Kapillare dieses zweiten Werkzeuges geführt und mittels einer Flamme oder einer elektrischen Entladung das unten an der Kapillare des zweiten Werkzeuges herausstehende Golddrahtende angeschmolzen, sodass sich durch die Oberflächenspannung eine Kugel bzw. ein Ball bildet. Diese Kugel bzw. dieser Ball des Golddrahtes wird unter Druck, Wärme und Ultraschall auf die Anschlussfläche 6 des Halbleiterkörpers 5 des zweiten integrierten Schaltkreises IC2 aufgesetzt. Der Golddraht wird anschließend vom Werkzeug abgerissen, sodass lediglich das kugelförmige Zwischenelement 20 mit einem stiftförmigen Fortsatz auf dem Anschlusspad 6 verbleibt.

Figur 2 zeigt eine ähnliche Halbleiteranordnung wie Fig. 1. Der Unterschied besteht allerdings darin, dass der zweite integrierte Schaltkreis IC2 mit seinem Halbleiterkörper 5 unmittelbar auf dem Halbleiterkörper 2 des ersten integrierten Schaltkreises IC1 aufsitzt. Das Anschlusspad 6 des zweiten integrierten Schaltkreises IC2 ist mit dem Anschlusspad 3 des ersten integrierten Schaltkreises IC1 über eine Bondleitung 10 aus Kupfer in Verbindung. Auf dem Anschlusspad 3 des ersten integrierten Schaltkreises IC1 sitzt das kugelförmige Ende 12 der Bondleitung 10, während das keilförmige Ende 14 der Bondleitung 10 wiederum über das Zwischenelement 20 auf dem Anschlusspad 6 des zweiten integrierten Schaltkreises IC2 sitzt.

Wenngleich in den Figuren 1 und 2 lediglich eine einzige Bondleitung 10 zum elektrischen Verbinden des ersten integrierten Schaltkreises IC1 und des zweiten integrierten Schaltkreises IC2 illustriert ist, versteht es sich, dass eine Vielzahl solcher Bondleitungen zum elektrischen Verbinden von integrierten Schaltkreisen innerhalb eines Gehäuses 1 vorgesehen werden müssen. Es können bspw. mehrere Hundert solcher Bondleitungen 10 vorgesehen sein.

Figur 3 zeigt drei solcher Bondleitungen 10 im Bereich ihrer keilförmigen Enden 14, wie diese über Zwischenelemente 20 auf Anschlusspads 6 eines integrierten Schaltkreises elektrisch angeschlossen sind. In Fig. 3 sind deutlich die rechteckförmigen Anschlusspads 6 zu erkennen. Auf den Anschlusspads 6, sitzt das Zwischenelement 20, das vorzugsweise aus Gold besteht, auf. Dieses Zwischenelement 20 ist in der Rasterelektronenaufnahme nicht mehr als kugelförmig zu erkennen, sondern es scheint so, dass sich, unmittelbar auf dem Anschlusspad ein tellerförmiges Teil 20a mit darüber befindlichem stiftförmigen Fortsatz 20b befindet. Das tellerförmige Teil 20a des Zwischenelementes 20 und der stiftförmige Fortsatz 20b sind einstückig miteinander verbunden und lediglich in der Rasterelektronenaufnahme so zu sehen, als ob es zwei Elemente sind. Dies ist allerdings nicht der Fall. Das tellerförmige Teil 20a mit dem stiftförmigen Fortsatz 20b entsteht dadurch, dass die Kapillare des Werkzeuges das kugelförmig bereitgestellte Zwischenelement 20 etwas zusammendrückt, und ein kleiner Teil beim Abreißen des Golddrahtes an diesem kugelförmigen Element 20 verbleibt. Dieser kleine Teil, der vom kugelförmigen Teil 20a stehen bleibt, ist der stiftförmige Fortsatz 20b in Figur 3.

### Bezugszeichenliste

- 1: Gehäuse
- 2: Halbleiterkörper
- 3: Anschlusspad
- 5: Halbleiterkörper
- 6: Anschlusspad

- 10: Bondleitung
- 12: kugelförmiges Ende
- 14: keilförmiges Ende

- 20: kugelförmiges Zwischenelement

- IC1: erster integrierter Schaltkreis
- IC2: zweiter integrierter SChaltkreis

## Patentansprüche

1. Halbleiteranordnung mit mindestens zwei in einem Gehäuse (1) angeordneten, integrierten Schaltkreisen (IC1, IC2), welche über Bondleitungen (10) miteinander elektrisch verbunden sind, wobei mindestens eine der Bondleitungen (10) mit einem Ende (12) an ein erstes Anschlusspad (3) des ersten integrierten Schaltkreises (IC1) und mit einem zweiten, keilförmig zulaufendem Ende (14) mit einem auf einem Anschlusspad (6) des zweiten integrierten Schaltkreises (IC2) aufsitzenden und elektrisch leitfähigen Zwischenelements (20) elektrisch verbunden ist,
**dadurch gekennzeichnet, dass**
die Bondleitung (10) aus einem anderen Material als das Zwischenelement (20) besteht, und dass das Material des Zwischenelementes (20) weicher als das Material der Bondleitung (10) ist.

2. Halbleiteranordnung nach Anspruch 1,
**dadurch gekennzeichnet, dass**
das Material der Bondleitung (10) Kupfer oder eine Kupferlegierung ist.

3. Halbleiteranordnung nach Anspruch 1 oder 2,
**dadurch gekennzeichnet, dass**
das Zwischenelement (20) aus Gold, einer Goldlegierung oder dotiertem Gold besteht.

4. Halbleiteranordnung nach einem der Ansprüche 1 bis 3,
**dadurch gekennzeichnet, dass**
das Zwischenelement (20) kugel- oder annähernd kugelförmig bereitgestellt ist.

5. Halbleiteranordnung nach einem der Ansprüche 1 bis 4,
**dadurch gekennzeichnet, dass**
das erste Ende der Bondleitung (10) eine kugel- oder annähernd kugelförmige Form aufweist.

6. Halbleiteranordnung nach einem der Ansprüche 1 bis 5,
**dadurch gekennzeichnet, dass**
die Bondleitung (10) einen Durchmesser von etwa 20-30 µm hat.

7. Halbleiteranordnung nach einem der Ansprüche 1 bis 6,
**dadurch gekennzeichnet, dass**
das Material der Bondleitung (10) eine Vickershärte ≤ 70 hat.

8. Halbleiteranordnung nach einem der Ansprüche 1 bis 7,
**dadurch gekennzeichnet, dass**
der erste integrierte Schaltkreis (IC1) und zweite integrierte Schaltkreis (IC2) nebeneinander angeordnet sind.

9. Halbleiteranordnung nach einem der Ansprüche 1 bis 7,
**dadurch gekennzeichnet, dass**
der erste integrierte Schaltkreis (IC1) und der zweite integrierte Schaltkreis (IC2) übereinander angeordnet sind und der zweite integrierte Schaltkreis (IC2) auf dem ersten integrierten Schaltkreis (IC1) aufsitzt.

10. Verfahren zum Herstellen einer Halbleiteranordnung nach einem der Ansprüche 1 bis 9 mit folgenden Schritten:
- Bereitstellen eines ersten integrierten Schaltkreises (IC1) mit mindestens einem ersten Anschlusspad (3),
- Bereitstellen eines zweiten integrierten Schaltkreises (IC2) mit mindestens einem zweiten Anschlusspad (6),
- Bereitstellen einer Bondleitung zum elektrischen Verbinden des ersten Anschlusspads (3) und des zweiten Anschlusspads (6),
- Aufbringen eines elektrisch leitfähigen Zwischenelements auf dem Anschlusspad (6) des zweiten integrierten Schaltkreises (IC2) derart, dass das elektrisch leitfähige Zwischenelement (20) elektrisch leitend mit dem Anschlusspad (6) des zweiten integrierten Schaltkreises (IC2) in Verbindung steht,
- mechanisches Befestigen eines ersten Endes (12) der Bondleitung (10) auf dem Anschlusspad (3) des ersten integrierten Schaltkreises (IC1),
- mechanisches Befestigen eines zweiten, keilförmigen Endes (14) der Bondleitung (10) auf dem Zwischenelement (20), wobei
- das Material des Zwischenelementes (20) weicher gewählt wird als das Material der Bondleitung (10).

11. Verfahren nach Anspruch 10,
**dadurch gekennzeichnet, dass**
das Zwischenelement (20) als kugel- oder annähernd kugelförmiges Element auf das Anschlusspad (6) des zweiten integrierten Schaltkreises (IC2) aufgebracht wird und

12. Verfahren nach Anspruch 10 oder 11,
**dadurch gekennzeichnet, dass**
die Bondleitung (10) mittels Ball-Wedge-Bonden auf dem ersten integrierten Schaltkreis (IC1) und zweiten integrierten Schaltkreis (IC2) befestigt wird, indem das erste Ende (12) der Bondleitung (10) als Kugel auf dem Anschlusspad (3) des ersten integrierten Schaltkreises (IC1) angeschmolzen und das keilförmige zweite Ende (14) der Bondleitung (10) als Wedge-Bond ausgebildet wird.
